Europäisches Patentamt

European Patent Office

Office européen des brevets

(11) Veröffentlichungsnummer: **0 225 501**
**A2**

# (12) EUROPÄISCHE PATENTANMELDUNG

(21) Anmeldenummer: 86115649.5

(22) Anmeldetag: 11.11.86

(51) Int. Cl.⁴: **C30B 31/10**

(30) Priorität: 11.11.85 DE 3539981

(43) Veröffentlichungstag der Anmeldung:
16.06.87 Patentblatt 87/25

(84) Benannte Vertragsstaaten:
**DE FR GB NL**

(71) Anmelder: **Telog Systems GmbH**
**Käthe-Kollwitz-Strasse 3a**
**D-8033 Martinsried(DE)**

(72) Erfinder: **Hokynar, Jiri, Dipl.-Ing.**
**Käthe-Kollwitz-Strasse 3a**
**D-8033 Martinsried(DE)**

(74) Vertreter: **Geissler, Bernhard, Dr. Patent- und**
**Rechtsanwälte et al**
**Bardehle-Pagenberg-Dost-**
**Altenburg-Frohwitter & Partner Postfach 86**
**06 20**
**D-8000 München 86(DE)**

(54) Verfahren und Vorrichtung zur Behandlung von Halbleitermaterialien.

(57) Eine Vorrichtung zur Wärmebehandlung von insbesondere Halbleiter-Wafers weist eine Heizeinrichtung auf, die in axialer Richtung mit Hilfe einer linearen Verschiebeeinrichtung über ein Quarzrohr geschoben werden kann, in dem sichdie zu behandelnden Materialien befinden. Bei dem Verfahren wird zunächst die schädliche Atmosphäre zumindest teilweise aus dem Quarzrohr entfernt und die Halbleiter-Wafers werden dann der Behandlungsatmosphäre ausgesetzt, und der erhitzte Ofen wird anschließend über das Quarzrohr bewegt.

EP 0 225 501 A2

## Verfahren und Vorrichtung zur Behandlung von Halbleitermaterialien

Die vorliegende Erfindung bezieht sich auf Diffusionsöfen. Außerdem bezieht sich die Erfindung auf ein Verfahren zur Behandlung von Halbleiter-Wafers.

Es ist bekannt, Materialien wie Halbleiter-Wafers in Quarzrohren verschiedenen Behandlungsverfahren zu unterziehen. Insbesondere können Halbleiter-Wafers durch Kontaktierung mit einer Dotiermateralien enthaltenden Atmosphäre bei hoher Temperatur dotiert werden. Ganz allgemein besteht bei diesem Verfahren das Problem, daß derartige Behandlungsstufen möglichst unter vollständiger Vermeidung von Kontamination durchgeführt werden müssen. Da Halbleiter-Wafers be diesem Verfahren mechanisch in das Quarzrohr eingebracht werden müssen, sind diese Halbleiter-Wafers immer einer nicht vollständig reinen Atmosphäre ausgesetzt. Bei bekannten Verfahren wurden die Halbleiter-Wafers in das heiße Quarzrohr eingeführt. Danach wurde das Rohr verschlossen und die Behandlungsatmosphäre wurde in das Quarzrohr eingeführt. Damit erfolgte also die anfängliche Behandlung in einem Gemisch von Laboratmosphäre und Spülgas. Die Halbleiter-Wafers waren von Anfang an der hohen Temperatur ausgesetzt.

Um sich daraus ergebende Nachteile zu beseitigen, wurde bereits vorgeschlagen, vor das Quarzrohr eine Vorkammer zu schalten, durch die über eine mit Dichtungen versehene Durchführung, die Halbleiter-Wafers durch die Vorkammer in die Hauptbehandlungskammer, nämlich das Quarzrohr, bewegt würden. Bei diesem System ist das Problem der sich vermischenden Atmosphären etwas verbessert, jedoch ergab sich das neue Problem, daß die Temperaturverteilung in dem erhitzten Quarzrohr sehr uneinheitlich wurde aufgrund der starken Abstrahlung durch die Öffnung des Quarzrohres in die Vorkammer. Dieses Problem ist um so signifikanter, je größer der Innendurchmesser des Quarzrohres bzw. je größer der Durchmesser der zu behandelnden Halbleiter-Wafers wird.

Der Erfindung liegt daher die Aufgabe zugrunde, ein Verfahren und eine Vorrichtung zur Behandlung und insbesondere Dotierbehandlung von Halbleiter-Wafers zu schaffen, bei dem sowohl eine gleichförmige Temperaturverteilung in dem Quarzrohr als auch eine definierte Atmosphäre bei der Behandlung ermöglicht wird.

Diese Aufgabe wird erfindungsgemäß durch eine Vorrichtung sowie ein Verfahren gelöst, wie es in den Ansprüchen näher gekennzeichnet ist.

Bei der erfindungsgemäßen Vorrichtung, im folgenden mit Diffusionsofen bezeichnet, bei dem das Quarzrohr vorzugsweise horizontal angeordnet ist, wird das Material, insbesondere die Halbleiter-Wafers, in das Rohr in "kaltem" Zustand eingebracht. Das Rohr wird verschlossen und die gewünschte Atmosphäre wird in dem Rohr erzeugt. Insbesondere kann dies durch anfängliches Evakuieren und darauf folgendes Einbringen der Behandlungsatmosphäre beschehen. Danach wird eine Heizung über das Quarzrohr gebracht, und die Halbleiter-Wafers werden einer sehr gleichmäßigen Erhitzung ausgesetzt. Insbesondere ergibt sich eine gleichmäßige Temperaturverteilung, wenn in dem Verschlußstück des Quarzrohres noch ein zusätzliches Heizelement angeordnet ist, und wenn die über das Quarzrohr gebrachte Heizung am Ende auch mit einem heizbaren Isolierverschluß versehen ist.

Die bevorzugten zu behandelnden Materialien sind Halbleiter-Wafers, wie sie z.B. bei der Herstellung von Mikroschaltkreisen und Chips verwendet werden, insbesondere Silizium-Wafers. Das Quarzrohr kann aus aus anderem hitzebeständigen Material bestehen, jedoch wird hier durchgehend die Bezeichnung des bevorzugten Materials, Quarz, zur Kennzeichnung der Aufnahmekammer für das Behandlungsmaterial verwendet.

Typischerweise werden die Silizium-Wafers in dem Quarzrohr bei Abscheide-bzw. Temperprozessen Temperaturen von 400 bis 800 C und bei Oxidations-bzw. Diffusionsprozessen Temperaturen von 900 bis 1300 C ausgesetzt.

Weitere bevorzugte Ausführungsformen der Erfindung ergeben sich aus der Zeichnung, in der

Fig. I einen teilweise weggebrochenen Querschnitt durch einen erfindungsgemäßen Diffusionsofen, und

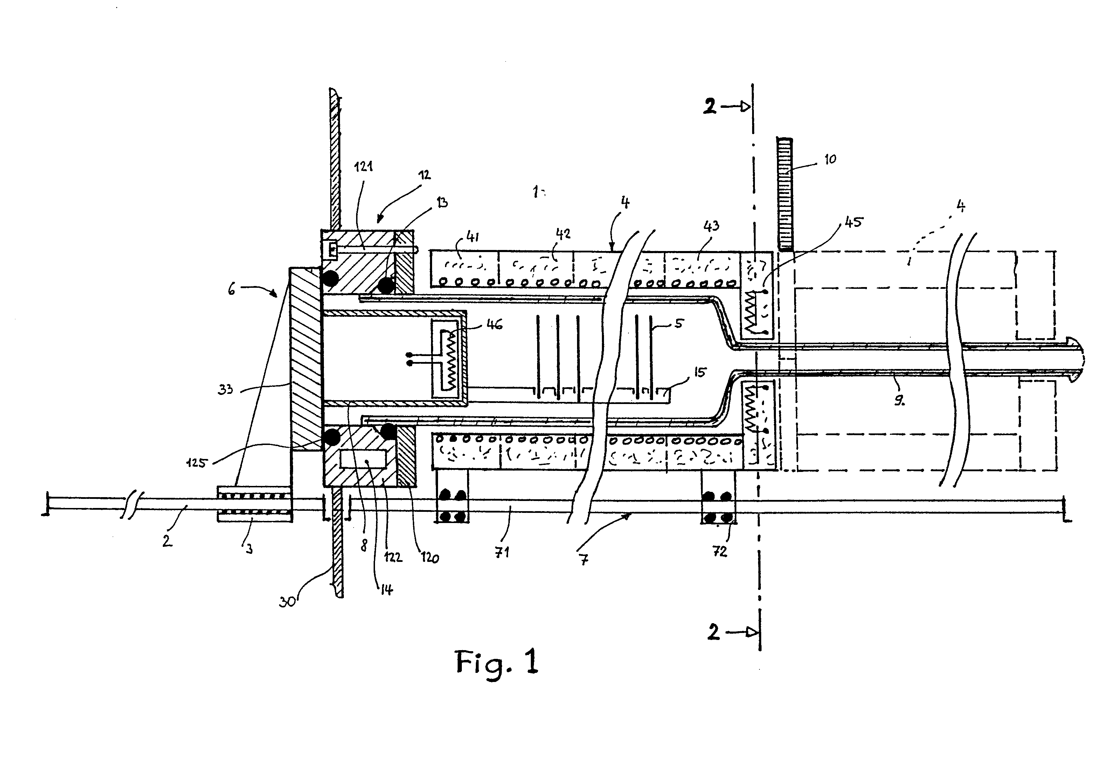

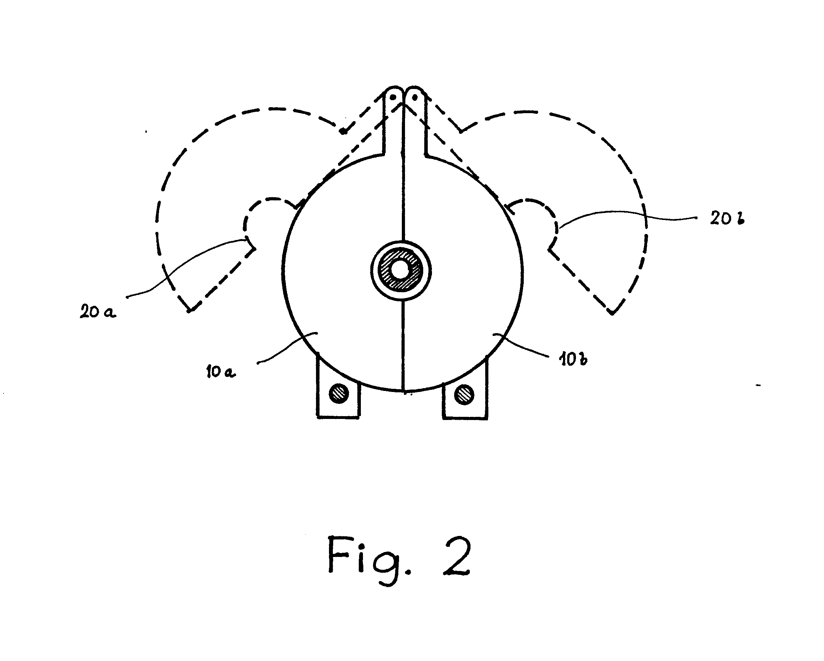

Fig. 2 eine Schnittansicht längs der Linie 2-2 in Fig. I mit zurückgefahrener Heizeinrichtung darstellen.

Gemäß Fig. I weist der erfindungsgemäße Diffusionsofen ein Quarzrohr I auf, das in ein vorzugsweise koaxiales Gaszuführungsrohr 9 übergeht. In dieses Quarzrohr können Halbleiter-Wafers 5 auf einem Paddle I5 eingebracht werden. Bei der in Fig. I gezeigten Ausführungsform ist das Paddle I5 fest mit dem Ansatz 8 eines Verschlußstücks 6 verbunden. Das Verschlußstück 6 samt Ansatz 8, Paddle I5 und Halbleiter-Wafers 5 kann entlang einer Linear-Verschiebungseinrichtung, wie beispielsweise einer Schiene 2 linear ver schoben werden, auf der diese Einrichtungen mit Hilfe von Kugellagerbuchsen 3 geführt ist.

Falls die Halbleiter-Wafers 5 in dem Quarzrohr I abgesetzt werden sollen, können hierzu brauchbare bekannte Vorrichtungen verwendet werden. In diesem Falle würde der das Paddle I5 nach Absetzen eines die Halbleiter-Wafers 5 enthaltenden Tisches in dem Quarzrohr linear aus dem Quarzrohr herausgeführt, während ein Verschlußteil 6, welches ähnlich dem in Fig. I gezeigten Verschlußteil ausgebildet ist, vor das Quarzrohr geschwenkt und in dichtendem Abschluß zu dem Quarzrohr verschoben wird.

Eine Heizeinrichtung 4, die vorzugsweise aus mehreren Heizelementen 4I, 42, 43 besteht, ist linear verschiebbar angeordnet. Die Heizeinrichtung 4 kann mit Hilfe einer mechanischen Linear-Verschiebungseinrichtung, wie beispielsweise Schienen 7I und Kugellagerrollen 72 oder auch Rädern erfolgen. In Fig. I ist die Heizeinrichtung 4 in dem Zustand dargestellt, in dem sie das Quarzrohr I während der Behandlung umgibt. Gestrichelt ist in Fig. I die Position der Heizeinrichtung 4 dargestellt, in der das Quarzrohr I sich in "kaltem" Zustand befindet und mit Wafers beladen wird. Um eine Strahlung der Heizeinrichtung 4 auf die Halbleiter-Wafers in zurückgezogenem Zustand zu verhindern, sind gemäß Fig. 2 zwei Blendenelemente I0a und I0b vorgesehen, die, eine Blende bildend, vor die Öffnung der Heizeinrichtung 4 in deren zurückgezogenem Zustand verschwenkt werden, die dann einen thermischen Abschluß des Heizelementes bilden. 80 Diese Isoliersegmente I0a und I0b enthalten eine Ausnehmung 20a bzw. 20b, die im zusammengeführten Zustand das Gaszuführungsrohr 9 möglichst anliegend umfassen.

Am hinteren Ende der Heizeinrichtung 4 ist eine Isolierplatte 45 vorgesehen, in der ebenfalls ein weiteres Heizelement angeordnet ist. Auch in der Abschlußeinrichtung 6 am freien Ende des Ansatzes 8 ist ein Heizelement 46 angeordnet. Mit Hilfe dieser zusätzlichen Heizelemente läßt sich eine besonders gleichförmige Temperaturverteilung in dem Quarzrohr I erreichen.

Auf dem Äußeren des offenen Endes des Quarzrohres I ist eine Metallabschlußhülse I2 angeordnet. Bei der in Fig. I dargestellten Ausführungsform weist diese Abschlußhülse I2 einen Andruckring I20 auf, der mit axialen Schrauben I2I gegen den festen Ring I22 gezogen wird. Ein Dichtring I3 zwischen den Ringen I20 und I22 dichtet die Metallendhülse gegenüber dem Äußeren des Quarzrohres ab. In dem äußeren Ring I22 ist ein Kühlkanal I4 vorgesehen, in dem Kühlflüssigkeit zirkuliert werden kann. Aus Übersichtlichkeitsgründen in der Zeichnung nicht dargestellt sind isolierte Durchführkanäle durch den festen Ring I22, vorgesehen für Thermoelemente, Gaszufuhr und Gasabfuhr. Der feste Ring I22 ist mit einer Trennwand 30 verbunden. In der Fig. I

befindet sich links von der Trennwand der Reinraum, während der Raum rechts von der Trennwand 30 keinerlei besonderen Anforderungen an die Reinheit der Atmosphäre genügen muß.

Zwischen der Metallendhülse I2 und dem Endflansch 33 des Verschlußstückes 6 ist ein Dichtungsring I25 angeordnet.

Die in das Quarzrohr I eingeführten Wafers 5 werden in kaltem Zustand von kontaminierter Atmosphäre weitgehend befreit, vorzugsweise durch Evakuieren über Evakuierungskanäle, die durch die Metallendhülse, und insbesondere den Festring I22 verlaufen. Danach wird der Innenraum des Quarzrohrs I über das Gaszuführungsrohr 9 mit der Behandlungsatmosphäre angefüllt. Die Halbleiter-Wafers sind damit im kalten Zustand der Behandlungsatmosphäre gleichmäßig ausgesetzt. Die Segmente I0a und I0b werden auseinandergefahren und die Heizeinrichtung 4 wird linear in axialer Richtung über das Quarzrohr I geschoben, wodurch die Halbleiter-Wafers 5 in der Behandlungsatmosphäre erhitzt werden. Dadurch kann beispielsweise in der Atmosphäre vorhandenes Dotierungsmaterial in die Halbleiter-Wafers eindiffundiert werden. Der Behandlungsraum ist gleichmäßig mit dem Behandlungsmedium gefüllt, so daß alle Halbleiter-Wafers 5 derselben Behandlung ausgesetzt werden. Die Temperaturverteilung ist durch die Struktur des Diffusionsofens sehr einheitlich.

Nach der erfolgten Behandlung wird die Heizeinrichtung 4 zurückgezogen und in die in Fig. I gezeigte gestrichelte Stellung gebracht. Die Segmente I0a und I0b werden zusammengeführt, wodurch der Innenraum der Heizeinrichtung 4 abgeschlossen wird. Die Halbleiter-Wafers werden abkühlen gelassen, wobei ein Reingasstrom durch das Gaszuführungsrohr 9 aufrecht erhalten wird. Nach ausreichender Abkühlung der Halbleiter-Wafers 5 wird das Verschlußteil 6 entfernt und die behandelten Halbleiter-Wafers können entnommen werden.

## Ansprüche

I. Vorrichtung zur Wärmebehandlung insbesondere von Halbleiter-Wafers, mit

a) einem Quarzrohr (I), das an seinem offenen Ende die axiale Beladung mit zu behandelndem Material ermöglicht,

b) einer Einrichtung (2, 3) zum axialen Einfahren von zu behandelndem Material in das Quarzrohr (I),

c) einer Heizeinrichtung (4), die das Quarzrohr (I) umgebend die Aufheizung des zu behandelnden Materials (5) ermöglicht,

d) einer Verschlußeinrichtung (6) zum Verschließen des offenen Ende des Quarzrohres (l),

**gekennzeichnet durch**

e) eine Linear-Verschiebeeinrichtung (7), auf der die Heizeinrichtung angeordnet ist und mit deren Hilfe die Heizeinrichtung (4) axial über das Quarzrohr (l) geschoben und von diesem zurückgezogen werden kann.

2. Vorrichtung zur Wärmebehandlung insbesondere von Halbleiter-Wafers nach Anspruch l, dadurch gekennzeichnet, daß die Heizeinrichtung - (4) in an sich bekannter Weise eine Mehrzahl einzeln steuerbarer erster Heizelemente (4l, 42, 43) aufweist.

3. Vorrichtung zur Wärmebehandlung insbesondere von Halbleiter-Wafers nach Anspruch l oder 2, dadurch gekennzeichnet, daß die Heizeinrichtung (4) zylindrisch zum Umfassen des Quarzrohres (l) ausgebildet ist, und stirnseitig ein - scheibenartiges Isolierelement (45) mit einem elektrischen zweiten Heizelement aufweist.

4. Vorrichtung zur Wärmebehandlung insbesondere von Halbleiter-Wafers nach einem der Ansprüche l bis 3, dadurch gekennzeichnet, daß die Verschlußeinrichtung (6) einen im Betriebszustand in das Quarzrohr (l) ragenden Ansatz (8) aufweist, der an seinem freien Ende ein drittes Heizelement (46) aufweist.

5. Vorrichtung zur Wärmebehandlung insbesondere von Halbleiter-Wafers nach einem der Ansprüche l bis 4, dadurch gekennzeichnet, daß das Quarzrohr (l) mit zumindest einem länglichen Gaszuführungsrohr (9) kommuniziert.

6. Vorrichtung zur Wärmebehandlung insbesondere von Halbleiter-Wafers nach einem der Ansprüche l bis 5, gekennzeichnet durch eine Strahlungsabschirmblende (l0), die beweglich derart angeordnet ist, daß sie vor das offene Ende der von dem Quarzrohr (l) zurückgezogenen Heizeinrichtung (4) unter Ausbildung einer thermischen Abschirmung des inneren der Heizeinrichtung (4) bewegt werden kann.

7. Vorrichtung zur Wärmebehandlung insbesondere von Halbleiter-Wafers nach Anspruch 6, dadurch gekennzeichnet, daß die Strahlungsabschirmblende (l0) zumindest zwei Segmente (l0a, l0b) aufweist, die beweglich derart an geordnet sind, daß sie von der Rohrachse weg und zu dieser hin bewegt werden können.

8. Vorrichtung zur Wärmebehandlung insbesondere von Halbleiter-Wafers nach einem der vorhergehenden Ansprüche, dadurch gekennzeichnet, daß mit dem Äußeren des offenen Endes des Quarzrohres (l) eine Metallendhülse (l2) über einen Dichtring (l3) verbunden ist, die einen Kühlflüssigkeitskanal (l4) aufweist.

9. Vorrichtung zur Wärmebehandlung insbesondere von Halbleiter-Wafers nach Anspruch 8, dadurch gekennzeichnet, daß die Metallendhülse - (l2) mit zumindest einer gasdichten Durchführung versehen ist.

l0. Vorrichtung zur Wärmebehandlung insbesondere von Halbleiter-Wafers nach einem der Ansprüche 8 oder 9, dadurch gekennzeichnet, daß eine Gasabsaugeeinrichtung mit einer gasdichten Durchführung durch die Metallendhülse (l2) verbunden ist.

ll. Vorrichtung zur Wärmebehandlung insbesondere von Halbleiter-Wafers nach einem der Ansprüche 8 bis l0, dadurch gekennzeichnet, daß zumindest der Teil des Innenbereichs der Metallendhülse (l2), der der Atmosphäre des Inneren des Quarzrohres (l) ausgesetzt ist, mit einem temperatur-und chemikalienbeständigen Kunststoff überzogen ist.

l2. Vorrichtung zur Wärmebehandlung insbesondere von Halbleiter-Wafers nach einem der Ansprüche 8 bis ll, dadurch gekennzeichnet, daß der Kühlflüssigkeitskanal (l4) in der Metallendhülse (l2) über den gesamten Umfang der Metallendhülse verläuft.

l3. Verfahren zur Behandlung von Halbleiter-Wafers, dadurch gekennzeichnet, daß

a) Halbleiter-Wafers mit einem Durchmesser von l20 mm oder mehr in ein unbeheiztes Quarzrohr eingebracht werden,

b) schädliche Atmosphäre um die Halbleiter-Wafers zumindest teilweise aus dem Quarzrohr entfernt wird,

c) die Halbleiter-Wafers dann der Behandlungsatmosphäre ausgesetzt werden,

d) ein erhitzter Ofen über das Quarzrohr bewegt wird, die Halbleiter-Wafers erhitzt und der Behandlungsprozeß dadurch in Gang gesetzt wird.

l4. Verfahren nach Anspruch l3, dadurch gekennzeichnet, daß die schädliche Atmosphäre durch Evakuieren des Inneren des Quarzrohres entfernt wird.

l5. Verfahren nach Anspruch l3 oder l4, dadurch gekennzeichnet, daß die Halbleiter-Wafers im Behandlungsprozeß einer Dotiermaterial enthaltenen und/oder Oxidationsmittel enthaltenen Atmosphäre ausgesetzt werden.

l6. Verfahren nach Anspruch l5, dadurch gekennzeichnet, daß die Halbleiter-Wafers in dem Behandlungsprozeß auf eine Behandlungstemperatur von 900 bis l300 C erhitzt werden.

Fig. 1

0 225 501

Fig. 2

20 a

20 b

10 a

10 b

0 225 501